(19) Europäisches Patentamt
European Patent Office
Office européen des brevets

(11) **EP 1 289 140 B1**

(12) **EUROPEAN PATENT SPECIFICATION**

(45) Date of publication and mention
of the grant of the patent:
**10.10.2007 Bulletin 2007/41**

(51) Int Cl.:
***H03H 11/48*** *(2006.01)*

(21) Application number: **01830536.7**

(22) Date of filing: **10.08.2001**

(54) **Integrated electronic circuit including non-linear devices**

Elektronische integrierte Schaltung mit nichtlinearen Vorrichtungen

Circuit électronique intégré comportant des composants non-linéaires

(84) Designated Contracting States:
**DE FR GB IT**

(43) Date of publication of application:
**05.03.2003 Bulletin 2003/10**

(73) Proprietors:
• **STMicroelectronics S.r.l.**
**20041 Agrate Brianza (Milano) (IT)**
• **International Business Machines Corporation**
**Armonk, NY 10504 (US)**

(72) Inventors:
• **Zuffada, Maurizio**
**20041 Agrate Brianza (MI) (IT)**

• **Betti, Giorgio**
**20041 Agrate Brianza (MI) (IT)**
• **Chrappan Soldavini, Francesco**
**20041 Agrate Brianza (MI) (IT)**
• **Hassner, Martin Aureliano**
**Mountain View, CA 94040 (US)**

(74) Representative: **Botti, Mario**
**Botti & Ferrari S.r.l.,**
**Via Locatelli, 5**
**20124 Milano (IT)**

(56) References cited:
**US-A- 4 383 230       US-A- 4 644 306**
**US-A- 6 060 934**

**Description**

The present invention relates generally to a non-linear electronic device and, more particularly, to a non-linear capacitor.

More specifically, but not exclusively, the invention relates to an electronic circuit device that may be integrated on a semiconductor substrate. Moreover, the invention may be integrated or used in association with a circuit network including non-linear devices.

PRIOR ART

As is well known in this specific technical field, the data detection for transmission channels is based on the use of a network of non-linear devices.

Actually, data detection with non-linear devices is gaining more and more market attention because of the simplicity of the circuit network and a corresponding lower production cost.

A circuit network including non-linear devices requires that the non-linearity of such devices be well controlled and follow a well-defined rule. Only if these conditions are respected the resulting network could provide some advantages in data detection if compared with others more complex known solutions.

The devices used in this kind of network are usually capacitor and inductor that have a non-linear relation between capacitance and voltage for capacitor and inductance and current for inductor.

One of the main difficulties for manufacturing an integrated circuit network including non-linear devices is due to the fact that the non-linear components must be provided as discrete elements. As a matter of fact, an integrated non-linear capacitor or inductor is hard to realize according to the current technologies.

For instance, the US patent No. 6,166,604 relates to a semiconductor amplifier including a distortion compensating circuit. That amplifier comprises a non-linear amplifying element connected to an integrated capacitor preventing a direct current from flowing through a passive circuit. The integrated capacitor is realized in a known manner.

The US Patent 6,060,934 of Landolt discloses an integrated circuit including a pseudo-capacitor showing a linear behavior.

Up to now no solutions are known for easily integrating an electronic circuit including non-linear passive components.

The technical problem of the present invention is that of implementing non-linear passive devices into a semiconductor electronic circuit thus allowing the construction of a network of non-linear devices for data detection in transmission channels.

SUMMARY OF THE INVENTION

The scope of the invention is to provide a circuit to integrate a non-linear passive device and, more specifically, a non-linear capacitor. More specifically the scope of the invention is to provide a non linear capacitor with the following relationship:

$$C = C_0 \cdot \frac{1}{1 - k \cdot V_C{}^2}$$

The solution idea on which the invention is based is that of realizing such non-linear passive device by using active components that are connected in a feedback loop in order to emulate the same behavior of the non-linear passive device.

Therefore, the present invention utilizes active devices operating in a feedback loop to implement the function of non-linear capacitor.

The technical problem is solved by an integrated electronic circuit defined by the enclosed claim 1 and following.

Other objects, features, and advantages of the present invention will become apparent from the following detailed description. It should be understood, however, that the detailed description and specific examples, while indicating preferred embodiments of the present invention, are given by way of illustration only and various modifications may naturally be performed without deviating from the present invention.

A more complete understanding of the present invention may be had by reference to the following detailed description when taken in conjunction with the accompanying drawings wherein:

BRIEF DESCRIPTION OF THE DRAWINGS

FIG. 1 is a schematic blocks diagram of a first embodiment of an electronic circuit in accordance with the present invention;

FIG. 2 is a detailed schematic diagram of the electronic circuit of the present invention;

FIG. 3 is a graph showing the capacitance value versus voltage for the electronic circuit of figure 2;

FIG. 4 is a graph showing the charge value versus voltage for the electronic circuit of figure 2.

DETAILED DESCRIPTION

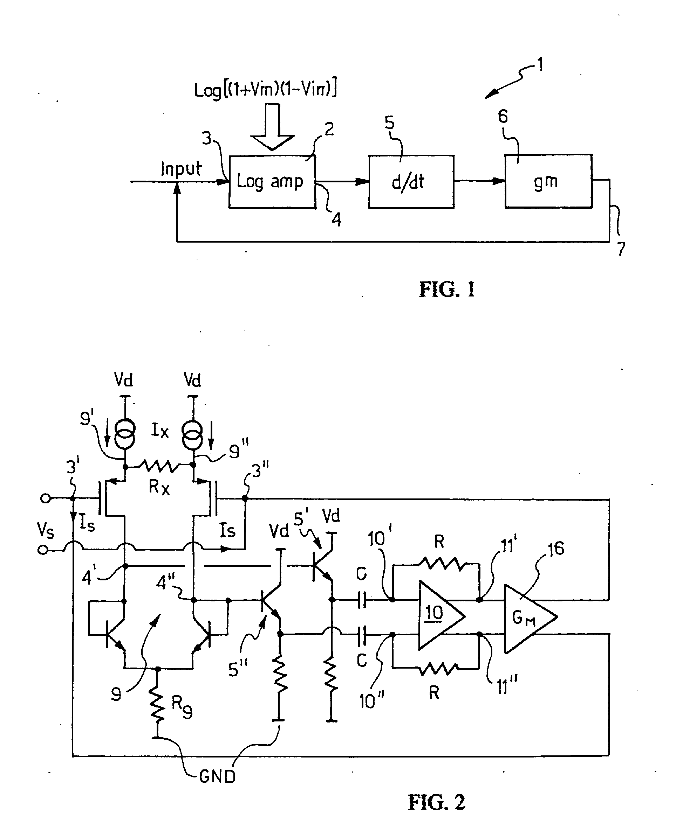

Referring now to figure 1, a schematic block diagram of an embodiment of an integrated electronic circuit 1 in accordance with the present invention is shown.
The integrated electronic circuit 1 implements a non-linear capacitor Ceq and, more specifically, a non linear capacitor having the following relationship:

$$C = C_0 \cdot \frac{1}{1 - k \cdot V_C^{2}}$$

The electronic circuit 1 includes a first logarithmic amplifier block 2 receiving an input current Iin at an input terminal 3.
The amplifier block 2 has an output 4 connected to an input of a derivative block 5 performing a d/dt function on the input signal.
A final gain block 6 is cascade downstream connected to the derivative block 5.
A feedback connection 7 closes a feedback loop between the output 8 of the gain block 6 and the input terminal 3.
The inventive solution is implemented by interconnecting several blocks into a feedback loop as shown in figure 1, thus realizing a non-linear capacitor.
The implemented function will be hereinafter explained starting with the relationship between voltage and current at the inputs terminals of the electronic circuit 1:

$$I_{in} = gm \cdot \frac{d}{dt}\left( \log\left( \frac{1 + V_{in}}{1 - V_{in}} \right) \right)$$

As may be appreciated, the gain term gm represents the function of the gain block 6, the d/dt () portion is the operative result presented by the output of the derivative block 5, while the logarithmic block 2 works on the input voltage signal Vin.
Now, solving the derivative term:

$$\frac{d}{dt}\left( \log\left( \frac{1 + V_{in}}{1 - V_{in}} \right) \right) = \frac{1}{\left( \frac{1 + V_{in}}{1 - V_{in}} \right)} \cdot \frac{\frac{dV_{in}}{dt} \cdot (1 - V_{in}) + \frac{dV_{in}}{dt} \cdot (1 + V_{in})}{(1 - V_{in})^2}$$

and simplifying:

$$\frac{\frac{dV_{in}}{dt} \cdot \left(1 - V_{in} + 1 + V_{in}\right)}{\left(1 + V_{in}\right) \cdot \left(1 - V_{in}\right)} = \frac{2 \cdot \frac{dV_{in}}{dt}}{\left(1 - V_{in}^2\right)}$$

we obtain a final result in the following relationship (Eq: 1):

$$I_{in} = gm \cdot \frac{d}{dt}\left(\log\left(\frac{1 + V_{in}}{1 - V_{in}}\right)\right) = gm \cdot \frac{2}{\left(1 - V_{in}^2\right)} \cdot \frac{dV_{in}}{dt} \qquad \mathrm{Eq:1}$$

As previously remarked, the relationship between voltage and current for a non-linear capacitor is the following:

$$I_c = C(V_C) \cdot \frac{dV_c}{dt} \qquad \mathrm{Eq:2}$$

By comparing the equations 1 and 2, a new relationship may be obtained (Eq: 3):

$$C(V_C) = gm \cdot \frac{2}{\left(1 - V_{in}^2\right)} \qquad \mathrm{Eq:3}$$

.

This equation (Eq:3) gives a relationship between current and voltage that follows the required behavior, apart for a factor that could be easily added by inserting a gain stage before the logarithmic amplifier.

As one possible embodiment of the inventive circuit 1 is shown in the schematic diagram of figure 2.

The logarithmic amplifier block 2 is implemented by a transconductance differential cell 9 having differential current inputs 3', 3" and corresponding current outputs 4', 4".

The cell 9 has a two symmetric transistor branches 9', 9" each coupled to a first voltage supply reference Vd through current generator Ix and to a second voltage reference GND through a resistor R9 or, as an alternative, a current generator.

The transistors of each branch 9', 9" could be bipolar transistors or a bipolar and a MOS transistor. More specifically, two input MOS transistors and two output bipolar transistors used in this embodiment. The current inputs 3', 3" are set between the current generator Ix and the first transistor of each branch 9', 9"; while the current outputs 4', 4" are set between the first and the second transistor of each branch.

Each current output 4', 4" is connected to the driving terminal of a bipolar transistor 5', 5" having the conduction terminal coupled to the first voltage reference Vd and to the second voltage reference GND, respectively. The second conduction terminal of each transistor 5', 5" is coupled to the second voltage reference GND trough a resistor or a current generator.

The second conduction terminal of each transistor 5', 5" is also coupled, through a capacitor C, to a corresponding input terminal 10', 10" of a double ended gain stage 10 having a resistor R feedback connected between each output 11', 11" and each input.

Both the output terminals 11', 11' of the gain stage 10 are connected to a double ended final gain block 16 having a gain factor Gh.

The outputs of the gain block 16 are feedback connected to the inputs terminals 3', 3" thus closing the feedback loop 7.

A resistor Rx is connected between the input terminals 3', 3" and an input voltage Vs is applied to the driving terminals of the input MOS transistors of the first logarithmic amplifier block 2.

The activity of the electronic circuit 1 shown in figure 2 may be summarized by the following relationship:

$$Is = G_H \cdot R \cdot C \cdot V_T \frac{d}{dT} \left\{ \ln \left( \frac{1 + \frac{V_s}{RxIx}}{1 - \frac{V_s}{RxIx}} \right) \right\} = Ceq \frac{dVs}{dt}$$

$$G_H$$

where Is is the input current, Gh is the gain value of the gain block 16, Vs is the input voltage, Rx is the input resistance, Ix is the biasing current and Ceq is the equivalent capacitance value of the whole circuit 1 according to the following formula:

$$Ceq = C \cdot \frac{G_H \cdot R \cdot 2V_T}{RxIx \left[ 1 - \left( \frac{Vs}{RxIx} \right)^2 \right]} = \frac{Co}{\left[ 1 - \left( \frac{Vs}{RxIx} \right)^2 \right]}$$

The corresponding charge value is:

$$Q = \int Is \cdot dt = C \cdot R \cdot G_H \cdot V_T \ln \left\{ \frac{1 + \frac{Vs}{IxRx}}{1 - \frac{Vs}{IxRx}} \right\}$$

Thus the capacitance value when the voltage Vs=0 is:

$$Co = C \cdot \frac{aV_T}{IxRx} \cdot G_H \cdot R$$

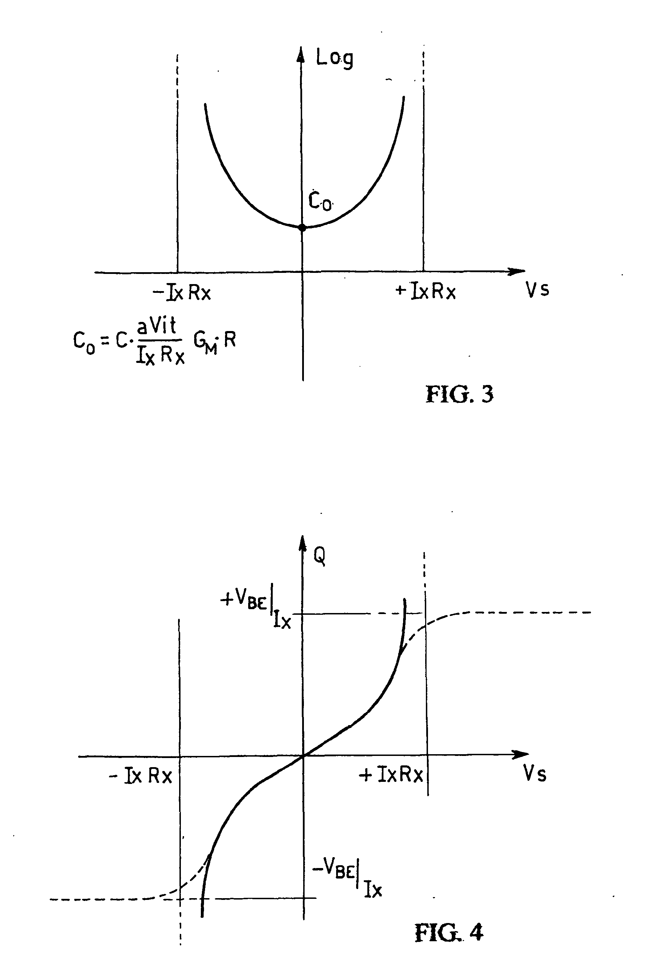

The graph diagram of the figures 4 and 5 show the evolution of capacitance value Cep and the charge value Q versus the voltage input Vs for the circuit of the invention.
Having described and illustrated the principles of the invention in a preferred embodiment thereof, it should be apparent that the invention can be modified in arrangement and detail without departing from such principles. We claim all modifications and variations coming within the scope of the following claims.

**Claims**

1. Integrated electronic circuit comprising at least one active block (2, 5, 6), **characterized in that** said at least one active block (2, 5, 6) comprises a logarithmic amplifier block (2) receiving an input current (Iin) at an input terminal (3) and having an output (4) coupled to said input terminal (3) by a feedback loop, so that said at least one active block (2, 5, 6) realizes a non-linear capacitor.

2. Integrated electronic circuit according to claim 1, **characterized in that** it further comprises a derivative block (5) downstream connected to said logarithmic amplifier block (2) and a final gain block (6) downstream connected to the derivative block (5), wherein said feedback loop is between an output of said gain block (6) and said input terminal (3) of said logarithmic amplifier block (2).

3. Integrated electronic circuit according to claim 1, **characterized in that** said logarithmic amplifier block (2) is implemented by a transconductor differential cell (9).

4.  Integrated electronic circuit according to claim 1, **characterized in that** said non-linear capacitor has the following relationship :

$$C = C_0 \cdot \frac{1}{1 - k \cdot V_C^2}$$

wherein $V_C$ is the input voltage at said integrated electronic circuit, k is a gain factor and Co is a capacitance value when the input voltage is zero.

**Patentansprüche**

1.  Integrierte elektronische Schaltung umfassend wenigstens einen aktiven Block (2, 5, 6), **dadurch gekennzeichnet, dass** der wenigstens eine aktive Block (2, 5, 6) einen logarithmischen Verstärkerblock (2) aufweist, der einen Eingangsstrom (Iin) an einem Eingangsanschluss (3) erhält und der einen Ausgang (4) aufweist, der mit dem Eingangsanschluss (3) über eine Rückkopplungsschleife gekoppelt ist, so dass der wenigstens eine aktive Block (2, 5, 6) eine nicht-lineare Kapazität realisiert.

2.  Integrierte elektronische Schaltung nach Anspruch 1, **dadurch gekennzeichnet, dass** sie weiterhin einen differenzierenden Block (5) aufweist, der dem logarithmischen Verstärkerblock (2) nachgeschaltet ist, und einen End-Verstärkungsblock (6), der dem differenzierenden Block (5) nachgeschaltet ist, wobei die Rückkopplungsschleife zwischen einem Ausgang des Verstärkungsblocks (6) und dem Eingangsanschluss (3) des logarithmischen Verstärkerblocks (2) vorhanden ist.

3.  Integrierte elektronische Schaltung nach Anspruch 1, **dadurch gekennzeichnet, dass** der logarithmische Verstärkerblock (2) durch eine Transkonduktanz-Differential-Zelle (9) implementiert ist.

4.  Integrierte elektronische Schaltung nach Anspruch 1, **dadurch gekennzeichnet, dass** die nicht-lineare Kapazität die folgende Beziehung aufweist:

$$C = C_0 \cdot \frac{1}{1 - k \cdot V_C^2}$$

wobei $V_C$ die Eingangsspannung an der integrierten elektronischen Schaltung, k ein Verstärkungsfaktor und $C_0$ ein Kapazitätswert ist, wenn die Eingangsspannung 0 ist.

**Revendications**

1.  Circuit électronique intégré comprenant au moins un bloc actif (2,5,6), **caractérisé en ce que** ledit au moins un bloc actif (2,5,6) comprend un bloc amplificateur logarithmique (2) recevant un courant d'entrée (Iin) au niveau d'une borne d'entrée (3) et comportant une sortie (4) couplée à ladite borne d'entrée (3) par une boucle de rétroaction, de façon à ce que ledit au moins un bloc actif (2,5,6) réalise un condensateur non linéaire.

2.  Circuit électronique intégré selon la revendication 1, **caractérisé en ce qu'**il comprend en outre un bloc de dérivation (5) en aval raccordé audit bloc amplificateur logarithmique (2) et un bloc de gain final (6) en aval raccordé au bloc de dérivation (5), dans lequel ladite boucle de rétroaction se trouve entre une sortie dudit bloc de gain (6) et ladite borne d'entrée (3) dudit bloc amplificateur logarithmique (2).

3.  Circuit électronique intégré selon la revendication 1, **caractérisé en ce que** ledit bloc amplificateur logarithmique (2) est mis en oeuvre par une cellule différentielle de transconducteur (9).

4.  Circuit électronique intégré selon la revendication 1, **caractérisé en ce que** ledit condensateur non linéaire présente la relation suivante :

$$C = C_0 \cdot \frac{1}{1 - k \cdot V_C^2}$$

dans laquelle $V_c$ est la tension d'entrée au niveau dudit circuit électronique intégré, k est un coefficient de gain et $C_o$ est une valeur de capacité lorsque la tension d'entrée est de zéro.

$$\mathrm{Log}\big[(1+\mathrm{Vin})(1-\mathrm{Vin})\big]$$

**FIG. 1**

**FIG. 2**

$$C_0 = C \cdot \frac{a\,Vit}{I_x\,R_x}\,G_M \cdot R$$

**FIG. 3**

**FIG. 4**

**EP 1 289 140 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6166604 A

- US 6060934 A